# EUROPÄISCHE PATENTSCHRIFT

(11) **EP 0 396 786 B1**
(45) Veröffentlichungstag und Bekanntmachung des Hinweises auf die Patenterteilung: **26.01.1994**
(21) Anmeldenummer: 89108255.4
(22) Anmeldetag: 08.05.1989
(51) Int. Cl.: H03M 3/02

(54) **Integrierbarer Sigma-Delta-Modulator in Switched-Capacitor-Technik**
Integrable sigma-delta modulator of the switched-capacitor type
Modulateur sigma-delta intégrable utilisant la technique des capacités commutées

(43) Veröffentlichungstag der Anmeldung: 14.11.1990
(73) Patentinhaber: SIEMENS AKTIENGESELLSCHAFT, 80333 München (DE)
(72) Erfinder: Koch, Rudolf, Dr. Ing., D-8025 Unterhaching (DE); Brazdrum, Helmut, Dipl.-Ing (FH), D-8000 München 40 (DE)

(56) Entgegenhaltungen:
- EP-A- 0 084 353
- EP-A- 0 104 988
- PATENT ABSTRACTS OF JAPAN, Band 9, Nr. 150 (E-324)[1873], 25. Juni 1985; & JP-A-60 31 315 (NIPPON DENKI K.K.) 18-02-1985
- 1986 IEEE INTERNATIONAL SOLID-STATE CIRCUITS CONFERENCE, 20. Februar 1986, Session XIV, Seiten 182-183, IEEE, New York, US; T. HAYASHI et al.: "A multistage delta-sigma modulator without double integration loop"
- PROCEEDINGS OF THE IEEE 1988 CUSTOM INTEGRATED CIRCUITS CONFERENCE, Rochester, New York, 16. - 19. Mai 1988, Seiten 21.3.1-21.3.4, IEEE, New York, US; S.R. NORSWORTHY et al.: "A 13-bit, 160 kHz sigma-delta A/D converter for ISDN"

## Beschreibung

Die Erfindung betrifft einen integrierbaren Sigma-Delta-Modulator mit einem Komparator, der durch ein erstes Steuersignal getaktet wird, und mit einem dem Komparator vorgeschalteten Integrierer, an dem eine Gegenkopplungsstufe angeschlossen ist und dem über eine Eingangsstufe mit einem ersten Schalter, einem ersten Kondensator und einem zweiten Schalter in Reihe ein Eingangssignal zugeführt wird, wobei die beiden Anschlüsse des ersten Kondensators über einen dritten bzw. vierten Schalter auf ein Bezugspotential aufschaltbar sind.

Ein derartiger Sigma-Delta-Modulator ist beispielsweise aus Patent Abstracts of Japan, Band 9, Nr. 150 (E-324) [1873], 25.06.1985, bekannt. Die Gegenkopplungsstufe besteht dabei aus einem dritten und vierten Kondensator, deren jeweils einer Anschluß über einen fünften bzw. sechsten Schalter auf einem Referenzpotential und über einen siebten bzw. achten Schalter auf ein Bezugspotential aufschaltbar ist und deren jeweils anderer Anschluß über einen neunten bzw. zehnten Schalter auf den Eingang des Integrators und über einen elften und zwölften Schalter auf das Bezugspotential aufschaltbar ist. Der erste, vierte, fünfte, achte, elfte und zwölfte Schalter werden durch ein erstes Steuersignal und zweiter, dritter, sechster, siebter und zehnter Schalter durch ein zweites Steuersignal geschaltet. Außerdem ist ein drittes Steuersignal vorgesehen, das durch UND-Verknüpfung aus dem zweiten Steuersignal und dem Ausgangssignal des Komparators hervorgeht und mit dem der siebte und neunte Schalter gesteuert werden.

Die Realisierung hochauflösender und hochlinearer Analog-Digital-Wandler mit Widerstands-, Transistor- oder Kondensatornetzwerken ist derzeit nur mit irgendeiner Form von Abgleich oder Korrektur möglich. Für manche Anwendungs fälle stellen daher Analog-Digital-Wandler mit Überabtastung und Rauschfilterung eine praktische Lösung dar. Dabei wird mit einer hohen Abtastfrequenz statt mit einer hohen Auflösung gearbeitet und in einem nachfolgenden digitalen, also unkritischen Filter, aus dem hochfrequenten Signal geringer Auflösung ein niederfrequentes Signal hoher Auflösung gewonnen.

Ein derartiger Analog-Digital-Wandler ist beispielsweise durch einen gattungsgemäßen Sigma-Delta-Modulator mit nachgeschaltetem Filter gegeben. Eine vereinfachte Beschreibung dieses Wandlertyps ist möglich, wenn ein Komparator (= 1-Bit-Analog-Digital-Wandler) als lineares Element mit der Übertragungsfunktion H = 1 betrachtet und ein zusätzliches unkorreliertes Quantisierungsrauschen N als Störgröße eingeführt wird. Daraus ergibt sich für das Ausgangssignal dieses Wandlers, daß das Eingangssignal linear übertragen wird und das Rauschen eine Hochpaßfilterung erfährt. Ein üblicher Sigma-Delta-Modulator zweiter Ordnung weist beispielsweise zwei Integratoren (= zweiter Ordnung), zwei Digital-Analog-Wandler und einen Komparator auf. Der erste Integrator ist dabei mit der Summe aus dem Eingangssignal des Sigma-Delta-Modulators und aus dem Ausgangssignal des ersten Digital-Analog-Wandlers beaufschlagt, während an den Eingang des zweiten Integrators die Summe aus dem Ausgangssignal des ersten Integrators und aus dem Ausgangssignal des zweiten Digital-Analog-Wandlers gelegt ist. Das Ausgangssignal des zweiten Integrators wird dem Komparator zugeführt. Der Ausgang des Komparators steuert die beiden Digital-Analog-Wandler direkt oder über Speicherelemente an.

Die Unempfindlichkeit gegen Parameterschwankungen kann jedoch weiter erhöht werden, wenn der Sigma-Delta-Modulator nicht mit RC-Gliedern zur Bestimmung der Zeitkonstanten, beispielsweise der Integratorzeitkonstanten, realisiert wird, sondern in Switched-Capacitor-Technik. Hierbei werden die Zeitkonstanten nicht mehr von der absoluten Größe eines Widerstandes R und eines Kondensators C bestimmt, sondern von dem wesentlich geringeren Schwankungen unterworfenen Verhältnis zweier geschalteter Kondensatoren.

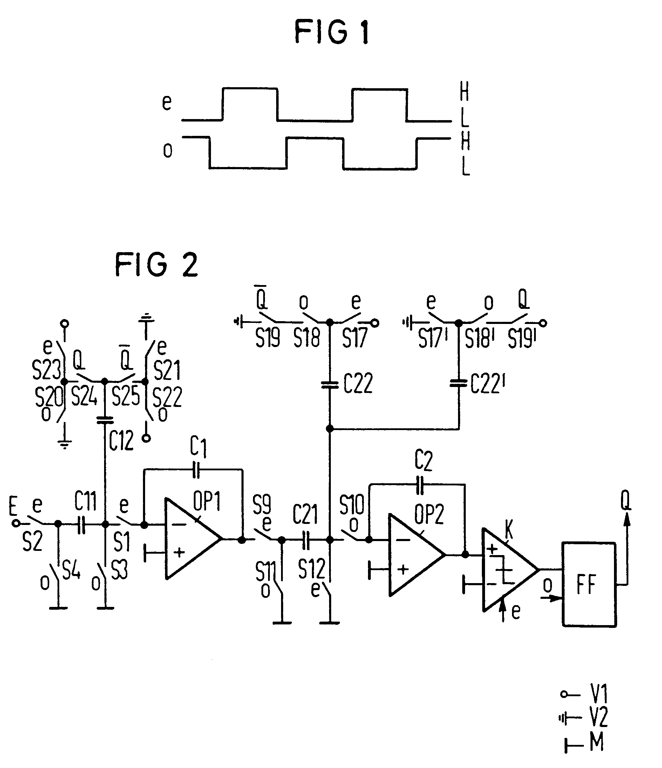

Die Ansteuerung der zum Schalten der Kondensatoren vorgesehenen Schalter erfolgt in zwei Phasen, nämlich einer Phase e und einer Phase o. Die zeitliche Zuordnung beider Phasen ist in Figur 1 der Zeichnung dargestellt. Zunächst ist die Phase e auf hohem Pegel H und die Phase o auf niedrigem Pegel L. Nach einem Signalwechsel der Phase e erfolgt nach kurzer Verzögerungszeit ein Signalwechsel der Phase o von niedrigem Pegel L zu hohem Pegel H. für eine gegebene Zeit führt nun die Phase o das Signal H.

Nach dem Signalübergang von H nach L der Phase o erfolgt nach kurzer Verzögerungszeit ein Signalwechsel von L nach H bei der Phase e. Nun führt wiederum die Phase e für eine gegebene Zeit das Signal H bis wiederum ein Wechsel erfolgt usw. Während die Phase e das Signal H führt wird eine an einem ersten Kondensator anliegende Spannung abhängig von der vorhergehenden Komparatorentscheidung aufintegriert. Der Komparator entscheidet nun über die Integration durch den zweiten Integrator während des Signales H der nachfolgenden Phase o und hält diesen Wert. Ein zweiter Kondensator wird daraufhin abhängig von dieser Komparatorentscheidung aufgeladen. Dabei arbeitet der zweite Integrator nicht. Führt nun die Phase o das Signal H, so integriert der zweite Integrator die an dem zweiten Kondensator anliegende Spannung als Funktion der Komparatorentscheidung während des Signales H der vorhergehenden Phase e. Der Komparator wird daraufhin zurückgesetzt und der Wert in einem Flip-Flop gespeichert. Der erste Kondensator wird nun abhängig von der Komparatorentscheidung in dem Zeitraum, in dem die Phase e das Signal H führt wiederum aufgeladen. Gleichzeitig wird ein mit dem Eingangssignal beaufschlagter Kondensator entladen. Dabei arbeitet der erste Integrator nicht.

Wie daraus zu ersehen ist, muß der Komparator bei jedem Signal H der Phase e die Integration des zweiten Integrators bewerten und abhängig von dieser Bewertung den zweiten Kondensator laden, damit beim Signal H der darauffolgenden Phase o mit der richtigen Spannung über dem zweiten Kondensator integriert werden kann. Aus diesen Gegebenheiten lassen sich folgende Anforderungen ableiten:
- Man benötigt einen Komparator mit sehr kurzer Bewertungszeit. Dies ist jedoch besonders kritisch, wenn die Eingangsspannungsdifferenz gegen Null geht, da hierbei die Bewertungszeit stark anwächst.
- Die mit dem zweiten Kondensator in Verbindung stehenden Schalter müssen größer ausgelegt werden als die um den ersten Kondensator, da bei gleichen Kapazitätswerten zum Aufladen des zweiten Kondensators weniger Zeit zur Verfügung steht.

Demzufolge wird die Ausführungsgeschwindigkeit des Sigma-Delta-Modulators von der Bewertungszeit des Komparators begrenzt.

Aufgabe der Erfindung ist es daher, einen Sigma-Delta-Modulator in Switched-Capacitor-Technik anzugeben, bei dem geringere Anforderungen an den Komparator bzw. die Schalter zu stellen sind.

Diese Aufgabe wird bei einem gattungsgemäßen Sigma-Delta-Modulator durch die kennzeichnenden Merkmale des Patentanspruches 1 gelöst. Eine Ausgestaltung des Erfindungsgedankens ist in einem Unteranspruch gekennzeichnet.

Vorteil der Erfindung ist es, daß bei konstanter Abtastrate die Anforderungen an den Komparator erheblich reduziert werden können bzw. bei gleichem Komparator die Abtastrate angehoben werden kann, was zu einer Erhöhung des Störabstandes führt.

Die Erfindung wird nachfolgend anhand von dem in den Figuren der Zeichnung dargestellten Ausführungsbeispiels näher erläutert, wobei gleiche Elemente mit gleichen Bezugszeichen versehen sind.

Es zeigt
- FIG 1: den Verlauf der Schaltphasen bei einem Sigma-Delta-Modulator in Switched-Capacitor-Technik und
- FIG 2: eine erste Ausführungsform eines erfindungsgemäßen Sigma-Delta-Modulators in Switched-Capacitor-Technik.
- FIG 3: eine zweite Ausführungsform eines erfindungsgemäßen Sigma-Delta-Modulators in Switched-Capacitor-Technik.

Gemäß FIG 2 der Zeichnung sind bei dem gezeigten Ausführungsbeispiel zwei Operationsverstärker OP1 und OP2 vorgesehen. Bei dem ersten Operationsverstärker OP1 ist zwischen Ausgang und invertierendem Eingang eine Kapazität C1 geschaltet. Der nichtinvertierende Eingang des ersten Operationsverstärkers OP1 liegt auf Bezugspotential M. Der invertierende Eingang ist über einen Schalter S1, über einen Kondensator C11 und über einen Schalter S2 mit einem Eingang E verbunden. Darüber hinaus ist der dem Eingang E zugewandte Anschluß des Kondensators C11 über einen Schalter S4 und dessen dem Eingang E abgewandter Anschluß über einen Schalter S3 auf Bezugspotential M abschaltbar. Der durch den Kondensator C11, den Schalter S1 gebildete Knotenpunkt ist zudem mit einem Kondensator C12 verbunden, dessen anderer Anschluß mit zwei Schaltern S24 und S25 beaufschlagt ist. Dem Schalter S24 ist dabei wiederum ein auf ein Potential V1 führender Schalter S24 und ein auf ein Potential V2 führender Schalter S20 nachgeschaltet. Ebenso ist dem Schalter S25 ein auf das Potential V1 führender Schalter S22 und ein auf das Potential V2 führender Schalter S21 nachgeschaltet.

Bei dem zweiten Operationsverstärker OP2 ist der Ausgang mit dem invertierenden Eingang über einen Kondensator C2 gekoppelt. Der Ausgang des ersten Operationsverstärkers OP1 ist über einen Schalter S9, einen Kondensator C21 und einen Schalter S10 mit dem invertierenden Eingang des zweiten Operationsverstärkers OP2 verbunden. Darüber hinaus ist der dem ersten Operationsverstärker OP1 zugewandte Anschluß des Kondensators C21 über einen Schalter S11 und der dem zweiten Operationsverstärker OP2 zugewandte Anschluß über einen Schalter S12 auf Bezugspotential M aufschaltbar. An den durch den Kondensator C21, dem Schalter S12 und dem Schalter S10 gebildeten Knotenpunkt sind zwei Kondensatoren C22 und C22′ angeschlossen. Der jeweils andere Anschluß des Kondensators C22 bzw. C22′ ist zum einen über einen Schalter S17 bzw. S17′ auf das Potential V1 bzw. das Potential V2 und zum anderen über einen Schalter S18 bzw. S18′ und S19 bzw. S19′ auf das Potential V2 bzw. V1 aufschaltbar. Der Ausgang des zweiten Operationsverstärkers OP2 ist auf den nichtinvertierenden Eingang eines Komparators K geführt, wessen invertierender Eingang ebenso wie der nichtinvertierende Eingang des Operationsverstärkers OP2 auf Bezugspotential M liegt. An den Komparator K wiederum ist ein Flip-Flop FF als Speicherelement angeschlossen, an dessen Ausgang ein Signal Q erscheint.

Die Ansteuerung der Schalter sowie die Taktung des Komparators K und des Flip-Flops FF erfolgt abhängig von den beiden Schaltphasen e und o nach FIG 1. Dabei werden die Schalter S1, S2, S21, S17, S17′, S9, S12 und S23 sowie der Komparator K mit der Schaltphase e gesteuert und die Schalter S4, S3, S20, S22, S11, S10, S18, S18′, sowie das Flip-Flop FF durch die Phase o. Darüber hinaus erfolgt die Steuerung der Schalter S24 und S19′ durch das Signal Q und der Schalter S19, S25 durch das invertierte Signal Q̅.

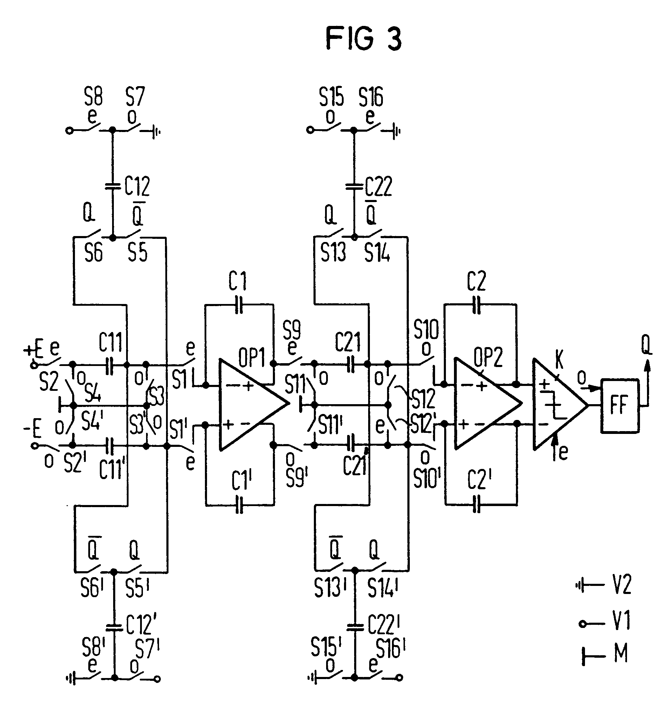

Gemäß FIG 3 der Zeichnung sind bei dem zweiten Ausführungsbeispiel ebenfalls die beiden Operationsverstärker OP1, OP2 vorgesehen. Bei dem ersten Operationsverstärker OP1 ist zwischen nichtinvertiertem Ausgang und invertierendem Eingang die Kapazität C1 und zwischen invertiertem Ausgang und nichtinvertierendem Eingang eine Kapazität C1′ geschaltet. Der invertierende Eingang des ersten Operationsverstärkers OP1 ist zudem über den Schalter S1, über den Kondensator C11 und über den Schalter S2 mit einem Eingang +E und der nichtinvertierende Eingang des ersten Operationsverstärkers OP1 über einen Schalter S1′, über einen Kondensator C11′ und über einen Schalter S2′ mit einem Eingang -E verbunden. Darüber hinaus ist der dem Eingang +E zugewandte Anschluß des Kondensators C11 über den Schalter S4 und dessen dem Eingang +E abgewandter Anschluß über den Schalter S3 bzw. der dem Eingang -E zugewandte Anschluß des Kondensators C11′ über einen Schalter S4′ und dessen dem Eingang -E abgewandter Anschluß über einen Schalter S3′ auf Bezugspotential M aufschaltbar.

Der durch den Kondensator C11, den Schalter S3 und den Schalter S1 gebildete Knotenpunkt ist zum einen über einen Schalter S6 mit dem Kondensator C12 und zum anderen über einen Schalter S6′ mit einem Kondensator C12′ verbunden. Ebenso ist der durch den Kondensator C11′, dem Schalter S3′ und dem Schalter S1′ gebildete Knotenpunkt über einen Schalter S5 mit dem Kondensator C12 und über einen Schalter S5′ mit dem Kondensator C12′ verbunden. Der andere Anschluß des Kondensators C12 bzw. C12′ ist zum einen über einen Schalter S8 bzw. S7′ auf ein Potential V1 und über einen Schalter S7 bzw. S8′ auf ein Potential V2 aufschaltbar.

Bei dem zweiten Operationsverstärker OP2 ist zwischen nichtinvertiertem Ausgang und invertierendem Eingang der Kondensator C2 und zwischen invertiertem Ausgang und nichtinvertierendem Eingang ein Kondensator C2′ geschaltet. Der nichtinvertierte Ausgang des ersten Operationsverstärkers OP1 ist über den Schalter S9, den Kondensator C21 und den Schalter S10 mit dem invertierenden Eingang des zweiten Operationsverstärkers OP2 verbunden. In gleicher Weise ist der invertierte Ausgang des ersten Operationsverstärkers OP1 über einen Schalter S9′, einen Kondensator C21′ und einen Schalter S10′ mit dem nichtinvertierenden Eingang des zweiten Operationsverstärkers OP2 verbunden. Darüber hinaus sind die dem ersten Operationsverstärker OP1 zugewandten Anschlüsse der beiden Kondensatoren C21 bzw. C21′, über den Schalter S11 bzw. S11′ und die dem zweiten Operationsverstärker OP2 zugewandten Anschlüsse über jeweils einen Schalter S12 bzw. S12′ auf Bezugspotential M aufschaltbar. An den durch den Kondensator C21, dem Schalter S12 und dem Schalter S10 gebildeten Knotenpunkt ist über einen Schalter S13 der Kondensator C22 und über einen Schalter S13′ der Kondensator C22′ angeschlossen.

Ebenso steht der durch den Kondensator C21′, dem Schalter S12′ und dem Schalter S10′ gebildete Knotenpunkt über einen Schalter S14 mit dem Kondensator C22 und über einen Schalter S14′ mit einem Kondensator C22′ in Verbindung. Der andere Anschluß des Kondensators C22 bzw. C22′ ist zum einen über einen Schalter S15 bzw. S16′ auf das Potential V1 und über einen Schalter S14 bzw. S13′ auf ein Potential V2 aufschaltbar.

Der nichtinvertierte Ausgang des zweiten Operationsverstärkers OP2 ist mit dem nichtinvertierenden Eingang eines Komparators K und der invertierte Ausgang des Operationsverstärkers OP2 mit dem invertierenden Eingang des Komparators K gekoppelt. Der Ausgang des Komparators K ist auf dem Eingang eines als Speicherelement vorgesehenen Flip-Flops FF geführt, wobei am Ausgang des Flip-Flops FF ein Ausgangssignal Q anliegt.

Die Schaltzyklen der Schalter S1, S1′ bis S16, S16′ sowie des Flip-Flops FF orientieren sich an dem grundlegenden Schaltverhalten der Phasen e und o. Die zeitliche Zuordnung beider Phasen ist in FIG 1 der Zeichnung dargestellt. Nach diesem Schema erfolgt fortlaufend die Generierung von Signalen der Phase e und der Phase o. Daraus abgeleitet werden nun die einzelnen Schalter jeweils durch unterschiedliche Signale angesteuert. Dabei werden die Schalter S1, S1′, S2, S2′, S8, S8′, S9, S9′, S12, S12′, S16, S16′ und der Komparator mit dem Signal der Phase e gesteuert. Bei den Schaltern S3, S3′, S4, S4′, S7, S7′, S11, S11′, S10, S10′, S15, S15′ und das Flip-Flop FF erfolgt die Ansteuerung mit dem Signal der Phase o. Die Schaltzyklen der Schalter S6, S5′ S13, S14′ sind durch das Ausgangssignal Q, die Schaltzyklen der Schalter S5, S6′, S13′, S14 sind durch das invertierte Ausgangssignal Q festgelegt.

In FIG 2 der Zeichnung ist ein Operationsverstärker, nämlich der als nichtinvertierend vorgesehene erste Operationsverstärker OP1, in herkömmlicher Art und Weise beschaltet, während die Beschaltung des als invertierender Integrator vorgesehenen zweiten Operationsverstärkers OP2 erfindungsgemäß realisiert ist. Nichtinvertierender und invertierender Integrator unterscheiden sich zunächst nur durch unterschiedliche Ansteuerung der Schalter in der Eingangsstufe. Die Eingangsstufe ist jeweils durch die Schalter S1 bis S4 und den Kondensator C11 bzw. durch die Schalter S9 bis S12 und den Kondensator C21 gegeben. Die Gegenkopplungsstufe ist dabei üblicherweise gemäß FIG 2 mit den Schaltern S19 bis S22 und dem Kondensator C12 aufgebaut. Bei der bekannten Lösung muß der Komparator K während des Zeitraumes in dem die Phase e bzw. die Phase o das Signal H führt, die Aufladung des Kondensators C12 mit einem der beiden Potentiale V1 oder V2 durchführen und in der verbleibenden Zeit die Entscheidung für den nächsten Zeitraum treffen. Erfindungsgemäß wird dagegen neben dem Kondensator C22 ein zusätzlicher Kondensator C22′ in Verbindung mit einer Umstellung der Schaltanordnung (bei gleicher Anzahl) verwendet und dadurch folgendes erreicht: Die Kondensatoren C22 und C22′ werden nun während der gesamten Dauer des Signales H der Phase e jeweils auf eine der beiden Spannungen V1, V2 aufgeladen. Gleichzeitig steht die Entscheidung des Komparators - die nun erst am Ende des H-Signals der Phase e abgeschlossen sein muß - ebenfalls die volle Dauer zur Verfügung. In der darauffolgenden Phase o integriert dann der zweite Integrator mit dem Operationsverstärker OP2 abhängig von der Komparatorentscheidung mit dem Kondensator C22 oder C22′. Dadurch können die Anforderungen an den Komparator erheblich reduziert werden bzw. bei gleichen Komparatoren die Abtastrate angehoben werden.

Neben der in FIG 2 gezeigten Ausführungsform ist darüber hinaus eine differentielle Ausgestaltung des Sigma-Delta-Modulators mit einer symmetrischen Beschaltung der Operationsverstärker OP1, OP2 gemäß FIG 3 möglich. Dazu werden jedoch in Ausgestaltung der Erfindung nicht vier Kondensatoren sondern weiterhin nur zwei Kondensatoren C22 und C22′ verwendet. Lediglich die Schalterbelegung ist wie in FIG 3 gezeigt, abgeändert.

## Patentansprüche

1. Sigma-Delta-Modulator (Figur 2),
mit einem Komparator (K), der durch ein erstes Steuersignal (e) getaktet wird, und mit einem dem Komparator (K) vorgeschalteten Integrierer (OP2, C2), an dem eine Gegenkopplungsstufe angeschlossen ist und dem über eine Eingangsstufe mit einem ersten Schalter (S9), einem ersten Kondensator (C21) und einem zweiten Schalter (S10) in Reihe ein Eingangssignal (E) zugeführt wird, wobei die beiden Anschlüsse des ersten Kondensators (C21) über einen dritten bzw. vierten Schalter (S11, S12) auf ein Bezugspotential (M) aufschaltbar sind, **dadurch gekennzeichnet**, daß erster sowie vierter Schalter (S9, S12) durch das erste Steuersignal (e) und zweiter sowie dritter Schalter (S10, S11) durch ein zum ersten Steuersignal (e) gegenphasiges zweites Steuersignal (o) geschaltet werden,
daß ein durch das zweite Steuersignal (o) getalrtetes, ein Ausgangssignal (Q) erzeugendes Speicherelement (FF) dem Komparator (K) nachgeschaltet ist, daß die Gegenkopplungsstufe einen zweiten und dritten Kondensator (C22, C22') aufweist, deren einer Anschluß an den Knotenpunkt von erstem Kondensator (C21) sowie zweitem und viertem Schalter (S10, S12) angeschlossen ist und deren jeweils anderer Anschluß über einen fünften bzw. sechsten Schalter (S17, S17') auf ein erstes bzw. zweites Potential (V1, V2) und über einen siebten und achten bzw. neunten und zehnten Schalter (S18, S19, S18', S19') auf das zweite bzw. erste Potential (V2, V1) aufschaltbar ist, und
daß fünfter und sechster Schalter (S17, S17') durch das erste Steuersignal (e), siebter und neunter Schalter (S18, S18') durch das zweite Steuersignal (o) und achter und zehnter Schalter (S19, S19') durch das invertierte bzw. nichtinvertierte Ausgangssignal (Q̅, Q) geschaltet werden.

2. Sigma-Delta-Modulator (Figur 3),
mit einem Komparator (K), der durch ein erstes Steuersignal (e) getaktet wird, und mit einem dem Komparator (K) vorgeschalteten Integrierer (OP2, C2), an dem eine Gegenkopplungsstufe angeschlossen ist und dem über eine Eingangsstufe mit einem ersten Schalter (S9), einem ersten Kondensator (C21) und einem zweiten Schalter (S10) in Reihe ein erstes Eingangssignal (+E) zugeführt wird, wobei die beiden Anschlüsse des ersten Kondensators (C21) über einen dritten bzw. vierten Schalter (S11, S12) auf ein Bezugspotential (M) aufschaltbar sind,
**dadurch gekennzeichnet**, daß erster sowie vierter Schalter (S9, S12) durch das erste Steuersignal (e) und zweiter sowie dritter Schalter (S10, S11) durch ein zum ersten Steuersignal (e) gegenphasiges zweites Steuersignal (o) geschaltet werden,
daß ein durch das zweite Steuersignal (o) getaktetes, ein Ausgangssignal (Q) erzeugendes Speicherelement (FF) dem Komparator (K) nachgeschaltet ist, daß der Integrator (OP2, C2, C2') symmetrisch ausgeführt ist und über eine weitere Eingangsstufe mit einem fünften Schalter (S9'), einen zweiten Kondensator (C21') und einen sechsten Schalter (S10') in Reihe durch ein zum ersten Eingangssignal (+E) symmetrisches zweites Eingangssignal (-E) angesteuert wird, wobei die beiden Anschlüsse des zweiten Kondensators (C21') über einen siebten bzw. achten Schalter (S11', S12') auf Bezugspotential (M) aufschaltbar sind, daß die Gegenkopplungsstufe einen dritten und vierten Kondensator (C22, C22') aufweist, deren jeweils einer Anschluß über einen neunten bzw. zehnten Schalter (S13, S13') auf den Knotenpunkt von erstem Kondensator (C21) sowie zweitem und viertem Schalter (S10, S12) und über einen elften bzw. zwölften Schalter (S14, S14') auf den Knoten von zweitem Kondensator (C21') sowie sechstem und achtem Schalter (S10', S12') aufschaltbar ist und deren jeweils anderer Anschluß über einen dreizehnten bzw. vierzehnten Schalter (S15, S16') auf das erste Potential (V1) und über einen fünfzehnten bzw. sechzehnten Schalter (S16, S15') auf das zweite Potential (V2) aufschaltbar ist, und
daß fünfter, achter, fünfzehnter und sechzehnter Schalter (S9', S12', S16, S16') durch das erste Steuersignal (e), sechster, siebter, dreizehnter und vierzehnter Schalter (S10', S11', S15, S15') durch das zweite Steuersignal (o), neunter und zwölfter Schalter (S13, S14') durch das nichtinvertierte Ausgangssignal (Q) sowie zehnter und elfter Schalter (S13', S14) durch das invertierte Ausgangssignal (Q̅) geschaltet werden.

3. Sigma-Delta-Modulator nach Anspruch 1 oder 2,
**dadurch gekennzeichnet**, daß der bzw. den Eingangsstufe(n) ein weiterer Integrator mit mindestens einer Gegenkopplungsstufe (S21 bis S25, C12) und mindestens einer Eingangsstufe (S1 bis S4, C11) vorgeschaltet ist.

## Claims

1. Sigma-delta modulator (Figure 2) having a comparator (K) which is pulsed by a first control signal (e) and having an integrator (OP2, C2) which is connected upstream of the comparator (K) and to which a negative-feedback stage is connected and to which an input signal (E) is supplied via an input stage having a first switch (S9), a first capacitor (C21) and a second switch (S10) in series, it being possible to connect the two connections of the first capacitor (C21) via a third switch and a fourth switch (S11, S12) to a reference potential (M), characterized in that first and fourth switches (S9, S12) are switched by the first control signal (e), and second and third switches (S10, S11) are switched by a second control signal (o) which is in antiphase to the first control signal (e), in that a storage element (FF), which is pulsed by the second control signal (o) and produces an output signal (Q), is connected downstream of the comparator (K), in that the negative-feedback stage has a second capacitor and a third capacitor (C22, C22') whose one connection is connected to the node point of the first capacitor (C21) and of the second and fourth switches (S10, S12), and whose other connection in each case can be connected via a fifth switch and a sixth switch respectively (S17, S17') to a first potential and a second potential respectively (V1, V2), and via a seventh switch and an eighth switch, as well as a ninth and a tenth switch respectively (S18, S19, S18', S19') to the second potential and first potential respectively (V2, V1), and in that fifth and sixth switches (S17, S17') are switched by the first control signal (e), seventh and ninth switches (S18, S18') by the second control signal (o) and eighth and tenth switches (S19, S19') by the inverted or non-inverted output signal (Q̅, Q).

2. Sigma-delta modulator (Figure 3) having a comparator (K) which is pulsed by a first control signal (e) and having an integrator (OP2, C2) which is connected upstream of the comparator (K) and to which a negative-feedback stage is connected and to which a first input signal (+E) is supplied via an input stage having a first switch (S9), a first capacitor (C21) and a second switch (S10) in series, it being possible to connect the two connections of the first capacitor (C21) via a third switch and a fourth switch (S11, S12) to a reference potential (M), characterized in that first and fourth switches (S9, S12) are switched by the first control signal (e), and second and third switches (S10, S11) are switched by a second control signal (o) which is in antiphase to the first control signal (e), in that a storage element (FF), which is pulsed by the second control signal (o) and produces an output signal (Q), is connected downstream of the comparator (K), in that the integrator (OP2, C2, C2') is designed in a symmetrical manner and is driven by a second input signal (-E), which is symmetrical with respect to the first input signal (+E), via a further input stage having a fifth switch (S9'), via a second capacitor (C21') and via a sixth switch (S10') in series, it being possible to connect the two connections of the second capacitor (C21') to reference potential (M) via a seventh switch and an eighth switch (S11', S12'), in that the negative-feedback stage has a third capacitor and a fourth capacitor (C22, C22') whose one connection in each case can be connected via a ninth switch and a tenth switch (S13, S13') to the node point of the first capacitor (C21) and of the second and fourth switches (S10, S12) and via an eleventh switch and a twelfth switch respectively (S14, S14') to the node of the second capacitor (C21') and of the sixth and eighth switches (S10', S12'), and whose other connection in each case can be connected via a thirteenth and a fourteenth switch respectively (S15, S16') to the first potential (V1) and via a fifteenth switch and a sixteenth switch respectively (S16, S15') to the second potential (V2), and in that fifth, eighth, fifteenth and sixteenth switches (S9', S12', S16, S16') are switched by the first control signal (e), sixth, seventh, thirteenth and fourteenth switches (S10', S11', S15, S15') by the second control signal (o), ninth and twelfth switches (S13, S14') by the non-inverted output signal (Q), and tenth and eleventh switches (S13', S14) by the inverted output signal (Q̅).

3. Sigma-delta modulator according to Claim 1 or 2, characterized in that a further integrator, having at least one negative-feedback stage (S21 to S25, C12) and at least one input stage (S1 to S4, C11) is connected upstream of the input stage or stages.

## Revendications

1. Modulateur sigma-delta (figure 2),
comportant un comparateur (K) qui est commandé de façon cadencée par un premier signal de commande (e), et un intégrateur (OP2, C2), qui est branché en amont du comparateur (K) et auquel est raccordé un étage de contreréaction et auquel un signal d'entrée (E) est envoyé par l'intermédiaire d'un étage d'entrée comportant un premier interrupteur (S9), un premier condensateur (C21) et un second interrupteur (S10) branchés en série, les deux bornes du premier condensateur (C21) pouvant être placées à un potentiel de référence (M) par l'intermédiaire de troisième et quatrième interrupteurs (S11,S12), caractérisé par le fait que les premier et quatrième interrupteurs (S9,S12) sont activés par le premier signal de commande (a), et les second et troisième interrupteurs (S10, S11) sont activés par un second signal de commande (o) d'une phase opposée à celle du premier signal de commande (e),
qu'un élément de mémoire (FF), qui est commandé de façon cadencée par le second signal de commande (o) et produit un signal de sortie (Q), est branché en aval du comparateur (K), que l'étage de contre-réaction comporte des second et troisième condensateurs (C22,C22'), dont une borne est raccordée au noeud de jonction du premier condensateur (C21) et des second et quatrième interrupteurs (S10,S12), et dont respectivement l'autre borne peut être placée à un premier ou à un second potentiel (V1,V2) par l'intermédiaire d'un cinquième ou d'un sixième interrupteur (S17,S17') et au second ou au premier potentiel (V2,V1) par l'intermédiaire d'un septième et d'un huitième ou d'un neuvième et d'un dixième interrupteurs (S18,S19,S18',S19'), et que les cinquième et sixième interrupteurs (S17,S17') sont fermés par le premier signal de commande (e), que les septième et neuvième interrupteurs (S18,S18') sont fermés par le second signal de commande (o) et que les huitième et neuvième interrupteurs (S19,S19') sont fermés par le signal de sortie inversé ou non inversé (Q̅,Q).

2. Modulateur sigma-delta (figure 3),
comportant un comparateur (K) qui est commandé de façon cadencée par un signal de commande (e) et un intégrateur (OP2, C2), qui est branché en amont du comparateur (K) et auquel est raccordé un étage de contre-réaction et auquel un premier signal d'entrée (+E) est envoyé, par l'intermédiaire d'un étage d'entrée comportant un premier interrupteur (S9), un premier condensateur (C21) et un second interrupteur (S10) branchés en série, les deux bornes du premier condensateur (C21) pouvant être placées à un potentiel de référence (M) par l'intermédiaire de troisième et quatrième interrupteurs (S11,S12),
caractérisé par le fait que les premier et quatrième interrupteurs (S9,S12) sont activés au moyen du premier signal de commande (e) et que le second et le troisième interrupteurs (S10,S20) sont activés par un second signal de commande (e) dont la phase est opposée à celle du premier signal de commande (e),
qu'un élément de mémoire (FF), qui est commandé de façon cadencée par le second signal de commande (o) et produit un signal de sortie (Q), est branché en aval du comparateur (Q), que l'intégrateur (OP2,C2,C2') est symétrique et est commandé par un second signal d'entrée (-E) symétrique du premier signal d'entrée (+E), par l'intermédiaire d'un autre étage d'entrée comportant un cinquième interrupteur (S9'), un second condensateur (C21') et un sixième interrupteur (S10') branchés en série, les deux bornes du second condensateur (C21') pouvant être placées au potentiel de référence (M) par l'intermédiaire de septième et huitième interrupteurs (S11',S12'),
que l'étage de contre-réaction comporte des troisième et quatrième condensateurs (C22,C22'), dont respectivement une borne peut être raccordée par l'intermédiaire de neuvième et dixième interrupteurs (S13,S13') au noeud de raccordement du premier condensateur (C21) et des second et quatrième interrupteurs (S10,S12) et, par l'intermédiaire de onzième et douzième interrupteurs (S14,S14') au noeud de raccordement du second condensateur (C21') et des sixième et huitième interrupteurs (S10',S12') et dont respectivement l'autre borne peut être placée au premier potentiel (V1) par l'intermédiaire de treizième et quatorzième interrupteurs (S15,S16') et au second potentiel (V2) par l'intermédiaire de quinzième et seizième interrupteurs (S16,S15'), et que des cinquième, huitième, quinzième et seizième interrupteurs (S9', S12', S16, S16') sont activés par le premier signal de commande (e), que les sixième, treizième et quatorzième interrupteurs (S10', S11', S15, S15') sont activés par le second signal de commande (o), que les neuvième et douzième interrupteurs (S13, S14') sont activés par le signal de sortie non inversé (Q) et que les dixième et onzième interrupteurs (S13', S14) sont activés par le signal de sortie inversé (Q̅).

3. Modulateur sigma-delta selon la revendication 1 ou 2, caractérisé par le fait qu'un autre intégrateur comportant au moins un étage de contre-réaction (S21 à S25, C12) et au moins un étage d'entrée (S1 à S4, C11) est branché en amont du ou des étages d'entrée.
